# EUROPÄISCHE PATENTSCHRIFT

(11) **EP 0 419 689 B1**
(45) Veröffentlichungstag und Bekanntmachung des Hinweises auf die Patenterteilung: **01.06.1994**
(21) Anmeldenummer: 89117654.7
(22) Anmeldetag: 25.09.1989
(51) Int. Cl.: H05K 7/14

(54) **Baugruppe mit einer Leiterplatte**
Assembly containing a circuit board
Ensemble à construire avec une plaque à circuits

(43) Veröffentlichungstag der Anmeldung: 03.04.1991
(73) Patentinhaber: SIEMENS AKTIENGESELLSCHAFT, 80333 München (DE)
(72) Erfinder: Deinhardt, Günther, Dipl.-Ing.FH, D-8450 Amberg (DE); Kasowski, Hermann, Dipl.-Ing.FH, D-8450 Amberg (DE); Schirbl, Reinhard, D-8460 Schwandorf (DE)

(56) Entgegenhaltungen:
- EP-A- 0 165 434
- DE-A- 2 928 668
- DE-U- 8 415 458

## Beschreibung

Die Erfindung betrifft Baugruppen mit einer Leiterplatte, die mit Anschlüssen versehen ist, mit einer Fronttür, einer an der Frontseite einer frontseitigen Rippe vorhandenen Zustandsanzeige und einem Frontstecker, der einer Kabelkanal zur Aufnahme von Kabeln aufweist, die über die Anschlüsse mit Leitungen auf der Leiterplatte elektrisch in Verbindung bringbar sind.

Baugruppen der obengenannten Art sind bereits bekannt (DE-U-84 15 458 und EP-A-0 165 434). Bei diesen ist die Fronttür frontseitig an der Rippe befestigt, was eine entsprechend breite Rippe voraussetzt. Zum Abnehmen der Frontstecker müssen die Fronttüren zuvor geöffnet werden. Beim Hantieren an den Frontsteckern ist die Fronttür hinderlich und außerdem besteht die Gefahr, daß eng benachbarte, geöffnete Fronttüren beschädigt werden. Die Breite der Baugruppen hängt auch von der Breite der vorstehenden Rippen ab, die bei bisherigen Baugruppen wesentlich durch die zur Zustandsanzeige aufgenommenen Leuchtdioden einschließlich ihrer Halterung bestimmt wird.

Der Erfindung liegt daher die Aufgabe zugrunde, eine Baugruppe der obengenannten Art mit geringerer Breite zu schaffen. Diese Aufgabe wird dadurch gelöst, daß bei obengenannter Baugruppe die Fronttür an dem Frontstecker angebracht ist, und daß die Zustandsanzeige mittels in der Rippe geführten Lichtleitern bewirkt wird, die als Verlängerungselemente von lichtemittierenden Leuchtelementen dienen. Mit dieser Ausführungsform verbinden sich außerdem folgende Vorteile. Durch die Fronttür an dem Frontstecker wird dieser auch zur Frontseite hin als geschlossene Einheit ausgebildet. Weiterhin werden Beschädigungen der Fronttür durch die Befestigung an dem Frontstecker seltener vorkommen als bei bisher bekannten Ausführungsformen mit an den Baugruppen angebrachten Fronttüren. Die Verwendung eines Lichtleiters, der zur Übertragung des von einem Leuchtelement ausgesendeten Lichts dient, ist im Hinblick auf die einzuhaltende Spannungsfestigkeit gegenüber elektrostatischen Entladungen von an der Frontseite angebrachten Bauteilen zur Elektronik in der Baugruppe vorteilhaft. Sind mehrere Lichtleiter zu einem Lichtleiterkamm zusammengefaßt, so wird hiermit der bei der Fertigung erforderliche Arbeitsaufwand zur Befestigung der Lichtleiter in der Rippe verringert. Eine automatengerechte Fertigung der vorgenannten Baugruppen ist möglich, wenn diese aus einer Gehäuseschale mit Positionierungsmitteln zur Positionierung der Leiterplatte sowie einem Gehäusedeckel aufgebaut sind. Weiterhin erweist es sich als vorteilhaft, wenn die Rippe durch einen zur Frontseite hin ragenden Steg an der Gehäuseschale und einem Gegenstück gebildet wird, das zum Gehäusedeckel gehört. Zur Befestigung des Frontsteckers an der Baugruppe sowie zur Kontaktierung der Anschlüsse mit Messern an derselben ist es günstig, wenn der Frontstecker aufschwenkbar ist. Bei der Fertigung der Baugruppe ist darauf zu achten, daß die Lichtleiter nicht verrutschen, nachdem sie in die Rippe eingelegt sind. Dies läßt sich in einfacher Weise erreichen, wenn die Lichtleiter verrastbar sind. Es erweist sich im Hinblick auf den Platzbedarf und der vorgenannten Ausleuchtung der Lichtleiter als günstig, wenn als Leuchtelemente Leuchtdioden verwendet werden. Üblicherweise werden Leuchtdioden mittels eines Halters befestigt, der einen mechanischen Schutz bietet. Darüber hinaus ist es jedoch zweckmäßig, wenn zur Halterung der Leuchtdioden Halter mit einem ersten Filmscharnier vorgesehen sind. Dies ermöglicht nämlich, die Leuchtdiode über das Filmscharnier so auszurichten, daß es eine bestimmte Stelle ausleuchtet, wobei der Befestigungsort des Halters verhältnismäßig freizügig gewählt werden kann.

Ist der Frontstecker mit einem Codierelement versehen, so läßt sich hiermit in einfacher Weise der irrtümliche Anschluß eines nicht passenden Frontsteckers vermeiden.

Die Befestigung der Baugruppe an einem Baugruppenträger ist leicht möglich, wenn die Baugruppe einen Schraubbolzen aufweist. Die Ausführung des Frontsteckers mit geringer Breite ist möglich, wenn die Fronttür über zweite Filmscharniere am Frontstecker klappbar befestigt ist.

In der Zeichnung ist ein Ausführungsbeispiel dargestellt, das im folgenden näher beschrieben wird. Es zeigen:
- FIG 1: einen Querschnitt durch eine Baugruppe,
- FIG 2: eine perspektivische Ansicht der demontierten Baugruppe mit Gehäuseschale, mit Leiterplatte und Gehäusedeckel,
- FIG 3: einen Lichtleiterkamm,
- FIG 4: eine perspektivische Ansicht der Baugruppe ohne Frontstecker und
- FIG 5: eine Teilansicht des Frontsteckers mit seiner Schwenkhalterung und einem Codierelement.

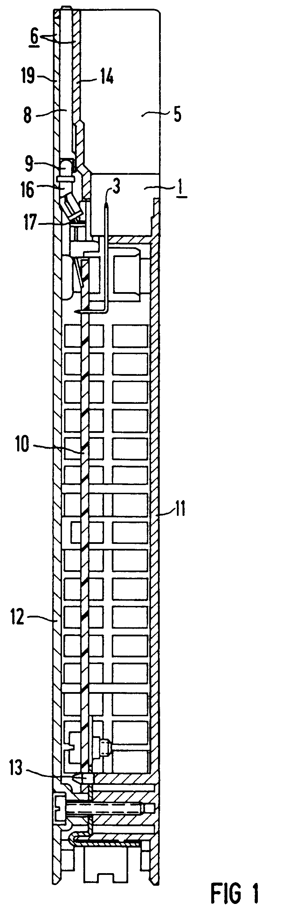

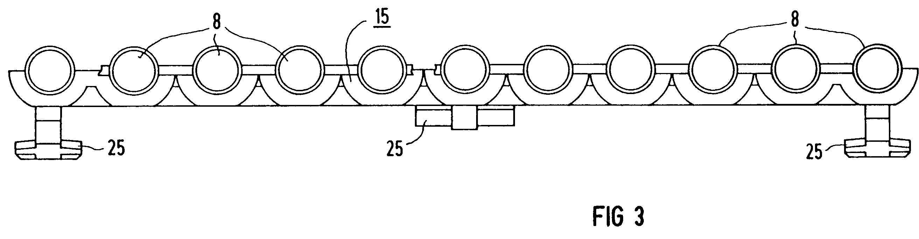

Die FIG 1 zeigt eine Baugruppe 1 mit einer zur Frontseite hin vorragenden Rippe 6 im Querschnitt. Die Baugruppe 1 enthält eine Gehäuseschale 11 mit Positionierungsmitteln 13, über die eine Leiterplatte 10 positioniert ist, sowie einen der Gehäuseschale 11 auf der anderen Seite der Leiterplatte 10 gegenüberliegenden Gehäusedeckel 12. Dieser automatengerechte Aufbau der Baugruppe ist in der europäischen Patentanmeldung mit der Bezeichnung "Baugruppen zum Anschluß an einen Baugruppenträger" (EP-A-0 419 694) näher beschrieben. Die vorstehende Rippe 6 wird durch einen Steg 14 der Gehäuseschale 11 sowie ein parallel dazu verlaufendes Gegenstück 19 als Teil des Gehäusedeckels 12 gebildet. In der Rippe 6 sind Lichtleiter 8 untergebracht, die mit dem Ende der Rippe 6 abschließen und deren anderes Ende an Leuchtdioden 9 geführt ist. Mehrere Lichtleiter 8 sind zwecks Vereinfachung der Fertigung zu einem Lichtleiterkamm 15 (siehe FIG 3) zusammengefaßt. Besonders hervorzuheben ist, daß wegen der geringen Dicke der Lichtleiter 8 die Rippe 6 in diesem Bereich sehr schmal ausgeführt ist und einen erweiterten Bereich aufweist zur Aufnahme der wesentlich breiteren Leuchtdioden 9. Diese Ausführung trägt zu einer schmalen Bauform der Baugruppe 1 bei. Zur Halterung der Leuchtdioden 9 ist ein Halter 16 mit einem Filmscharnier 17 vorgesehen, über das die Leuchtdiode 9 durch Umbiegen in die dem Lichtleiter 8 nahe Position gebracht werden kann. Dies erweist sich im Hinblick auf eine automatengerechte Fertigung der Baugruppe 1 besonders günstig, da hierdurch die Verlötung der Leuchtdiode 9 mit der Leiterplatte 10 zusammen mit der Verlötung der übrigen Bausteine auf derselben in einem Lötbad vorgenommen werden kann, wobei allerdings der Halter 16 zunächst noch nicht abgebogen ist. Erst nach der Verlötung der Leuchtdiode 9 wird diese mit dem Halter 16 über das Filmscharnier 17 in ihre zum Einsetzen in die Baugruppe 1 bestimmte Endposition umgebogen.

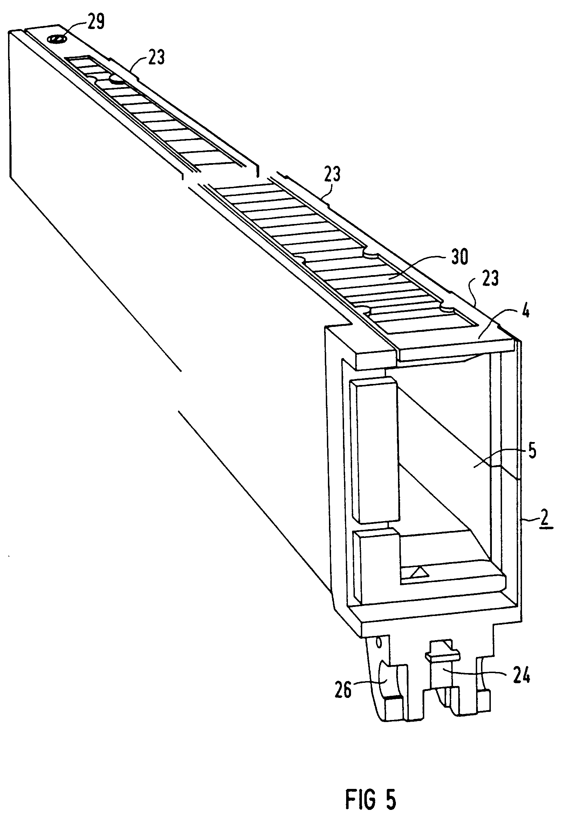

Neben der Rippe 6 findet der mit einer Fronttür 4 versehene Frontstecker 2 (siehe FIG 5) Platz, der einen zur Zustandsanzeige in der Rippe 6 parallel verlaufenden Kabelkanal 5 aufweist. Die Befestigung der Fronttür 4 an dem Frontstecker 2 über Filmscharniere 23 stellt eine weitere Maßnahme zur Reduzierung der Breite der Baugruppe 1 dar, da damit auf größeren Raum einnehmende Befestigungsmittel an der Baugruppe 1 selbst verzichtet werden kann. Der Frontstecker 2 weist an seinem einen Ende zum Aufschwenken auf die Baugruppe 1 eine Schwenkhalterung 26 mit einem dazwischenliegenden Codierelement 24 auf.

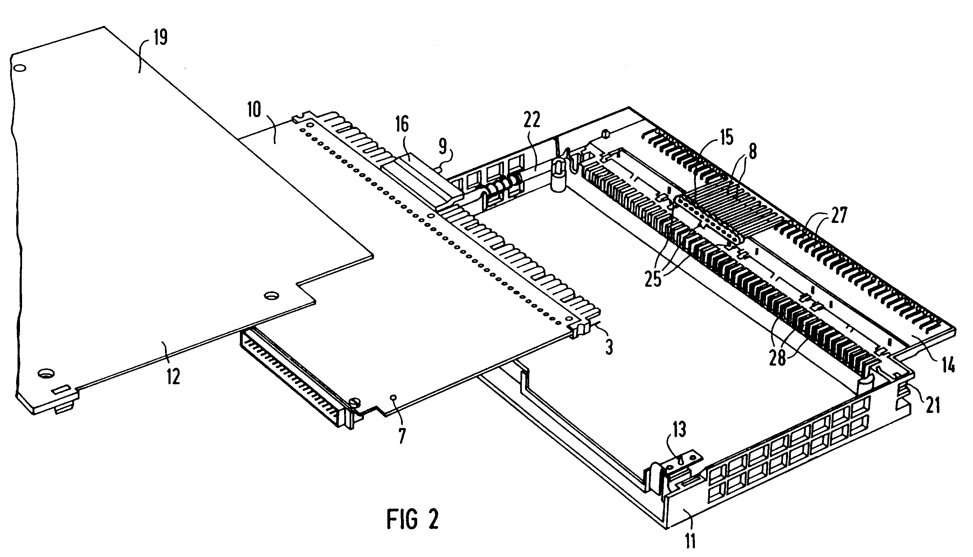

FIG 2 zeigt die in Einzelteile zerlegte Baugruppe 1 nach FIG 1 in perspektivischer Ansicht. Zu unterst ist die Gehäuseschale 11 mit dem Steg 14, mit dem an der Frontseite vorgesehenen Schwenklager 21 sowie Schraubbolzen 22 und einem als Positionierungsmittel dienenden Zapfen 13 zur Positionierung der Leiterplatte 10 dargestellt. Die Innenseite des Steges 14 ist mit Nuten 27 versehen, in die Lichtleiter 8, welche zu Lichtleiterkämmen 15 zusammengefaßt sind, unverrutschbar eingelegt werden können. Die Lichtleiterkämme 15 (siehe FIG 3) weisen zudem Verrastmittel 25 auf, über die sie in entsprechend ausgebildeten Öffnungen im Steg 14 der Gehäuseschale 11 verrastbar sind. Über der Gehäuseschale 11 ist die Leiterplatte 10 dargestellt, die mit Haltern 16 zur Aufnahme von Leuchtdioden 9 versehen werden kann. Nach Auflegen der Leiterplatte 10 auf die Gehäuseschale 11, bei dem der Zapfen 13 in ein entsprechendes Loch 7 der Leiterplatte 10 greift, wird die Baugruppe 1 durch einen Gehäusedeckel 12, der mit der Gehäuseschale 11 verschraubt wird, verschlossen.

Durch im Steg 14 vorgesehene Schlitze 28 können die Anschlüsse 3 an der Leiterplatte 10 nach außen hindurchgreifen, um somit die elektrische Verbindung mit Kabeln im Kabelkanal 5 des Frontsteckers 2 zu ermöglichen.

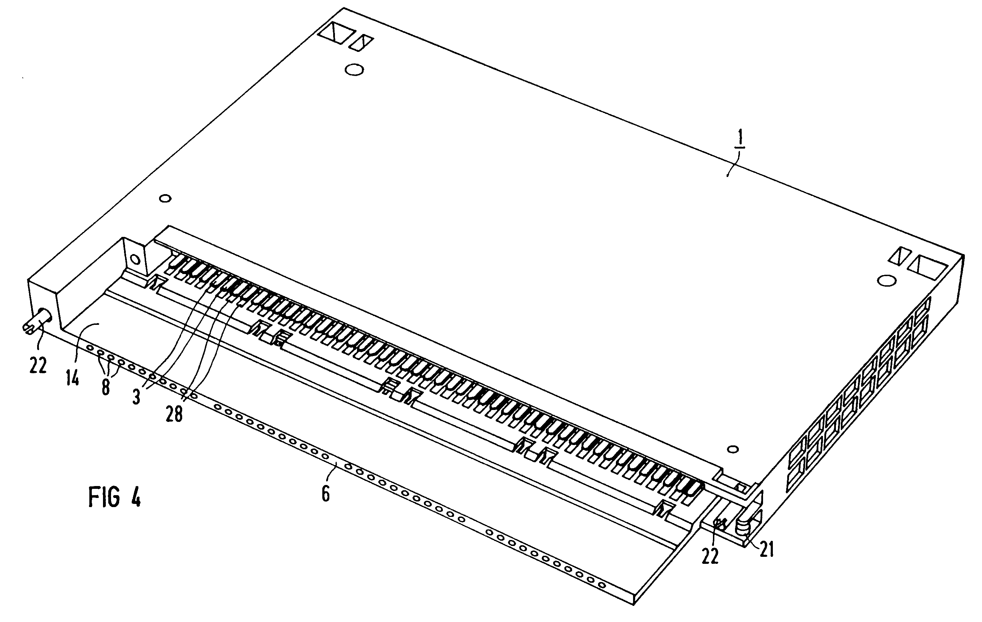

Die in FIG 4 dargestellte Baugruppe 1 wird über Schraubbolzen 22 an einem hier nicht dargestellten Baugruppenträger befestigt. Aus den Schlitzen 28 im Steg 14 ragen die Anschlüsse 3 hervor, für die an der Rückseite des Frontsteckers 2 ebenfalls Öffnungen vorgesehen sind, über welche Kabel im Kabelkanal 5 des Frontsteckers 2 mit diesen Anschlüssen 3 elektrisch verbunden werden können. Der Frontstecker 2 wird über die an das Schwenklager 21 der Baugruppe 1 angepaßte Schwenkhalterung 26 (siehe FIG 5) auf das Gehäuse der Baugruppe 1 aufgeschwenkt. Zur Befestigung des Frontsteckers 2 an der Gehäuseschale 11 weist dieser einen Befestigungsbolzen 29 auf, der von der Frontseite her betätigbar ist. Über die Fronttür 4 sind Kabel im Kabelkanal 5 des Frontsteckers 2 zugänglich. Die Fronttür 4 ist über Filmscharniere 23 am Frontstecker 2 klappbar befestigt und weist auf der im geschlossenem Zustand sichtbaren Frontseite ein einschiebbares Beschriftungsschild 30 mit Beschriftungsfeldern auf, die den danebenliegenden Leuchtanzeigen durch die Lichtleiter 8 zugeordnet sind.

FIG 5 zeigt den Bereich des Frontsteckers 2 mit der Schwenkhalterung 26, in die ein Codierelement 24 einsetzbar ist. Somit können mit diesem Codierelement 24 versehene Frontstecker 2 nur auf entsprechend angepaßte Gehäuse von Baugruppen 1 aufgeschwenkt werden. Ein irrtümlich falscher Anschluß solcher Frontstecker 2 auf nicht zugehörige Baugruppen 1 kann mit dem Codierelement 24 vermieden werden. Die FIG 5 zeigt außerdem einen Teil der hier geschlossenen Fronttür 4 mit dem Beschriftungsschild 30 auf ihrer Oberseite.

Die zuvor beschriebene Baugruppe 1 zur Zustandsanzeige zeichnet sich insbesondere durch einen einfachen Aufbau und ihre Fertigung in geradlinigen Abläufen aus, die eine Herstellung mittels Automaten ermöglicht. Durch bestimmte Maßnahmen ist eine besonders schmale Baugruppe geschaffen worden, die nur wenig Platz beansprucht und somit den Kundenbedürfnissen entgegen kommt.

## Patentansprüche

1. Baugruppe (1) mit einer Leiterplatte (10), die mit Anschlüssen (3) versehen ist, mit einer Fronttür (4), einer an der Frontseite einer frontseitigen Rippe (6) vorhandenen Zustandsanzeige und einem Frontstecker (2), der einen Kabelkanal (5) zur Aufnahme von Kabeln aufweist, die über die Anschlüsse (3) mit Leitungen auf der Leiterplatte (10) elektrisch in Verbindung bringbar sind, **dadurch gekennzeichnet,** daß die Fronttür (4) an dem Frontstecker (2) angebracht ist und daß die Zustandsanzeige mittels in der Rippe (6) geführten Lichtleitern (8) bewirkt wird, die als Verlängerungselemente von lichtemittierenden Leuchtelementen (9) zur Zustandsanzeige dienen.

2. Baugruppe nach Anspruch 1, **dadurch gekennzeichnet**, daß mehrere Lichtleiter (8) zu einem Lichtleiterkamm (15) zusammengefaßt sind.

3. Baugruppe nach Anspruch 1 oder 2, **gekennzeichnet durch** den Aufbau aus einer Gehäuseschale (11) mit Positionierungsmitteln (13) zur Positionierung der Leiterplatte (10) sowie einem Gehäusedeckel (12).

4. Baugruppe nach Anspruch 3, **dadurch gekennzeichnet**, daß die Rippe (6) durch einen zur Frontseite hin ragenden Steg (14) an der Gehäuseschale (11) und einem Gegenstück (19) gebildet wird, das zum Gehäusedeckel (12) gehört.

5. Baugruppe nach einem der vorhergehenden Ansprüche, **dadurch gekennzeichnet**, daß der Frontstecker (2) aufschwenkbar ist.

6. Baugruppe nach einem der vorhergehenden Ansprüche 2 bis 5, **dadurch gekennzeichnet**, daß die Lichtleiterkämme (15) verrastbar sind.

7. Baugruppe nach einem der vorangehenden Ansprüche, **dadurch gekennzeichnet,** daß als Leuchtelemente Leuchtdioden (9) verwendet werden.

8. Baugruppe nach einem der vorangehenden Ansprüche, **dadurch gekennzeichnet,** daß zur Halterung der Leuchtdioden (9) Halter (16) mit einem ersten Filmscharnier (17) vorgesehen sind.

9. Baugruppe nach einem der vorangehenden Ansprüche, **dadurch gekennzeichnet**, daß ein Frontstecker (2) mit einem Codierelement (24) versehen ist.

10. Baugruppe nach Anspruch 9, **dadurch gekennzeichnet**, daß das Codierelement (24) im Bereich einer Schwenkhalterung (26) an dem Frontstecker (2) einsetzbar ist.

11. Baugruppe nach einem der vorangehenden Ansprüche, **dadurch gekennzeichnet**, daß die Baugruppe (1) Schraubbolzen (22) aufweist.

12. Baugruppe nach einem der vorangehenden Ansprüche, **dadurch gekennzeichnet**, daß die Fronttür (4) über zweite Filmscharniere (23) am Frontstecker (2) klappbar befestigt ist.

## Claims

1. Module (1) with a printed circuit board (10) which is provided with terminals (3), with a front door (4), a status display present at the front side of a front rib (6) and a front connector (2) which has a cable duct (5) for accommodating cables, which can be brought into electrical connection by way of the terminals (3) with lines on the printed circuit board (10), characterized in that the front door (4) is fitted to the front connector (2) and in that the status display is effected by means of light guides (8) guided in the rib (6), which serve as elongation elements of light-emitting light elements (9) for the status display.

2. Module according to claim 1, characterized in that several light guides (8) are combined into one light-guide cam (15).

3. Module according to claim 1 or 2, characterized by the assembly from a housing shell (11) with positioning means (13) for positioning the printed circuit board (10) and a housing cover (12).

4. Module according to claim 3, characterized in that the rib (6) is formed by a bar (14) projecting towards the front side on the housing shell (11) and a counterpart (19) which belongs to the housing cover (12).

5. Module according to one of the preceding claims, characterized in that the front connector (2) can be pivoted on.

6. Module according to one of the preceding claims 2 to 5, characterized in that the light-guide cams (15) can be latched.

7. Module according to one of the preceding claims, characterized in that light-emitting diodes (9) are used as light elements.

8. Module according to one of the preceding claims, characterized in that to hold the light-emitting diodes (9) holders (16) with a first film hinge (17) are provided.

9. Module according to one of the preceding claims, characterized in that a front connector (2) is provided with a coding element (24).

10. Module according to claim 9, characterized in that the coding element (24) can be inserted in the region of a pivoted holder (26) on the front connector (2).

11. Module according to one of the preceding claims, characterized in that the module (1) has screw bolts (22).

12. Module according to one of the preceding claims, characterized in that the front door (4) is fastened in a hinged manner by way of second film hinges (23) on the front connector (2).

## Revendications

1. Module (1) comportant une plaquette à circuits imprimés (10), qui est munie de bornes (3), une porte avant (4), un dispositif d'affichage d'état disposée sur la face avant d'une nervure frontale (6), et un connecteur frontal (2), qui comporte un conduit (5) à câbles servant à loger des câbles qui peuvent être raccordés électriquement, par l'intermédiaire des bornes (3), à des conducteurs situés sur la plaquette à circuits imprimés (10), caractérisé par le fait que la porte frontale (4) est disposée sur le connecteur frontal (2) et que le dispositif d'affichage d'état est réalisé au moyen de fibres optiques (8), qui passent dans la nervure (6) et qui servent d'éléments de prolongement d'éléments éclairants photoémissifs (9) pour afficher l'état.

2. Module suivant la revendication 1, caractérisé par le fait que plusieurs fibres optiques (8) sont rassemblées en un peigne (15) de fibres optiques.

3. Module suivant la revendication 1 ou 2, caractérisé par le fait qu'il est constitué d'une coque de boîtier (11) comportant des moyens de mise en position (13) destiné à metttre la plaquette à circuits imprimés (10) ainsi qu'un couvercle de boîtier (12) en position.

4. Module suivant la revendication 3, caractérisé par le fait que la nervure (6) est formée d'une barrette (14), qui fait saillie du côté frontal sur la coque (11) du boitier, et d'une pièce antagoniste (19), qui fait partie du couvercle (12) du boîtier.

5. Module suivant l'une des revendications précédentes, caractérisé par le fait que le connecteur frontal (2) est monté basculant.

6. Module suivant l'une des revendications précédentes 2 à 5, caractérisé par le fait que les peignes (15) de fibres optiques sont encliquetables.

7. Module suivant l'une des revendications précédentes, caractérisé par le fait qu'on utilise des diodes à luminescence (9) comme éléments luminescents.

8. Module suivant l'une des revendications précédentes, caractérisé par le fait que pour la fixation des diodes à luminescence (9), il est prévu des supports (16) comportant une première charnière en forme de pellicule (17).

9. Module suivant l'une des revendications précédentes, caractérisé par le fait qu'un connecteur frontal (2) est muni d'un élément de codage (24).

10. Module suivant la revendication 9, caractérisé par le fait que l'élément de codage (24) peut être appliqué dans la zone d'un support pivotant (26) sur le connecteur frontal (2).

11. Module suivant l'une des revendications précédentes, caractérisé par le fait que le module (1) comporte un goujon fileté (22).

12. Module suivant l'une des revendications précédentes, caractérisé par le fait que la porte avant (4) est fixée de manière à être rabattable par l'intermédiaire de deux charnières en forme de pellicules (23) sur le connecteur frontal (2).
